# EUROPÄISCHE PATENTSCHRIFT

(11) **EP 1 052 886 B1**
(45) Veröffentlichungstag und Bekanntmachung des Hinweises auf die Patenterteilung: **07.07.2004**
(21) Anmeldenummer: 00109253.5
(22) Anmeldetag: 28.04.2000
(51) Int. Cl.: H05K 9/00

(54) **Anordnung zur EMV-Abschirmung**
EMI shielding device
Dispositif de blindage electromagnétique

(30) Priorität: 10.05.1999 DE 29908347 U
(43) Veröffentlichungstag der Anmeldung: 15.11.2000
(73) Patentinhaber: Knürr AG, 94424 Arnstorf (DE)
(72) Erfinder: Neuwardt, Klaus, 94436 Simbach b. Landau (DE); Prinz, Alexander, 84389 Postmünster (DE); Schneiderbauer, Siegfried, 94439 Rossbach (DE); Spateneder, Werner, 84347 Pfarrkirchen (DE)
(74) Vertreter: Heim, Hans-Karl, Dipl.-Ing.

(56) Entgegenhaltungen:
- EP-A- 0 207 226
- DE-C- 19 644 417
- DE-U- 29 502 404
- FR-A- 894 795
- US-A- 5 162 610
- US-A- 5 398 833

## Beschreibung

Die Erfindung betrifft eine Anordnung zur EMV-Abschirmung von Wandungen oder Teilen eines Gehäuses, insbesondere eines Tischgehäuses, gemäß dem Oberbegriff des Anspruchs 1.

Aus der DE 295 02 404 U1 ist eine EMV-abgeschirmte Anordnung mit zwei frontseitigen und zwei rückseitigen Querprofilen zwischen zwei Seitenteilen bekannt. Ein Deckblech und ein Bodenblech werden an den Seitenteilen mit Hilfe von Steckverbindungen befestigt. Als Steckverbindungen sind fingerartige Eingriffselemente, insbesondere an den Seitenteilen vorgesehen, welche mit komplementär ausgebildeten Aufnahmen, beispielsweise etwa trapezförmigen Ausbuchtungen, insbesondere in abgewinkelten Randschenkeln des Deckblechs und Bodenblechs zusammenwirken. Im Bereich der Steckverbindungen sind als EMV-Abschirmungen Kontaktnoppen ausgebildet, welche beim Einschieben der finderartigen Eingriffselemente in die Aufnahmen einen Materialabrieb und eine Kontaktierung bewirken.

Bei der bekannten Anordnung sind die front- und rückseitigen Querholme in das Boden- und Deckblech integriert. Eine EMV-Abschirmung erfolgt an der Frontseite über EMV-Federleisten, welche auf abgewinkelten Schenkeln der Frontplatten angeordnet werden.

Es ist bekannt, derartige Baugruppenträger mit einem Außengehäuse zu versehen und als Tischgehäuse zu verwenden.

Aus der EP 0 207 226 A1 ist ein hochfrequenzdichtes Gehäuse mit einem Gehäuseunterteil, einem Deckel und einem Federblechstreifen bekannt. Ein Deckelrand ist im Abstand zu den Gehäusewänden angeordnet, und der Federblechstreifen wird mit einem U-förmigen Befestigungsteil von oben auf die Gehäusewand oder alternativ von unten auf den Deckelrand aufgeschoben, derart, dass bogen- oder dachförmige Zungen den Deckelrand bzw. die Gehäusewand kontaktieren.

Aus der US-PS 5,162,610 ist ein EMV-abgeschirmtes Gehäuse mit einem Deckenteil und einem Bodenteil bekannt. Das Dekkenteil, welches längsseitig Randschenkel aufweist, und das Bodenteil, welches eine frontseitige und eine rückseitige Wand aufweist, bilden zusammen ein geschlossenes Gehäuse. Zur EMV-Abschirmung sind die längsseitigen Kantenbereiche des Decken- und Bodenteils mit einem relativ breiten, abgeschrägten Überlappungsbereich versehen, welcher von einem in das Gehäuseinnere gerichteten, V-förmigen und nach unten offenen Kanal am Deckenteil und einem komplementär ausgebildeten, schräg nach innen gerichteten Befestigungsflansch am Bodenteil gebildet wird. Zusätzlich ist eine EMV-Beschichtung vorgesehen.

Der Erfindung liegt die **Aufgabe** zugrunde, eine Anordnung zur EMV-Abschirmung von Wandungen oder Teilen eine Gehäuses, insbesondere von Seitenteilen und/oder Querprofilen gegenüber einem Deckblech und/oder Bodenblech zu schaffen, welche bei einem außerordentlich einfachen konstruktiven Aufbau eine rationelle Fertigung und besonders effiziente EMV-Abschirmung gewährleistet.

Erfindungsgemäß wird die Aufgabe durch die Merkmale des Anspruchs 1 gelöst. Zweckmäßige und vorteilhafte Ausgestaltungen sind Merkmale der Unteransprüche und in der Figurenbeschreibung beschrieben.

Die Grundidee der Erfindung besteht in einem EMV-Schirmungskonzept, welches auf labyrinthartig ausgebildeten Bereichen der Seitenteile, des Deckblechs und/oder des Bodenblechs basiert.

Erfindungsgemäß sind die Seitenteile an ihren oberen und/oder unteren Kantenbereichen, zweckmäßigerweise über ihre gesamte Tiefe, derart abgekantet oder abgebogen, daß labyrinthartige Kantenbereiche ausgebildet sind und ein montiertes Deckblech und/oder Bodenblech mit wenigstens zwei Auflagen auf- oder anliegt.

In einer vorteilhaften Ausbildung können die Abkantungen der Seitenteile als ein Labyrinthbug ausgebildet sein. Hohe Schirmdämpfungswerte zeigt ein labyrinthartig ausgebildeter Kantenbereich, welcher im Querschnitt etwa als ein liegendes "Z" oder als eine U- bzw. V-förmige Nut ausgebildet ist.

Erfindungsgemäß reichen erste Randschenkel des Deckblechs und/oder Bodenblechs jeweils über die labyrinthartigen Kantenbereiche, so daß diese abgedeckt sind. Dabei sind die ersten Randschenkel in der Regel 90° -Abwinklungen und verlaufen parallel zu den Seitenteilen.

Es ist besonders vorteilhaft, wenn die Länge der ersten Randschenkel des Deckblechs und/oder Bodenblechs derart ausgebildet ist, daß diese bei sehr hohen Frequenzen annähernd 4 Charakter aufweist. In die U- bzw. V-Nut gelangende elektromagnetische Wellen werden überraschend stark, insbesondere durch Reflexion und Absorption gedämpft.

Es ist sinnvoll, die labyrinthartigen Kantenbereiche, zumindest die Auflageflächen, ebenso wie die entsprechenden Auflagebereiche des Deckblechs und/oder des Bodenblechs frei von Lackierungen zu halten, so daß eine metallische Kontaktfläche vorhanden ist. Bei Ausbildung einer U- oder V-förmigen Nut mit einem innenseitigen Verbindungsschenkel und einem außenseitigen freien Schenkel, bezogen auf einen Innenraum des Gehäuses, ist es vorteilhaft, daß eine außenseitige Auflage an dem freien Schenkel bei einem montierten Deckblech in dessen Eckbereich angeordnet ist.

Von dem parallel zu den Seitenteilen verlaufenden, ersten Randschenkeln eines Deckblechs oder Bodenblechs wird bei entsprechender Länge der Randschenkel ein weiterer Zwischenraum mit den Seitenteilen gebildet. Außerdem besteht die Möglichkeit, daß die ersten Randschenkel mit zusätzlichen Wandelementen verlängert werden. In den Zwischenraum zwischen den Randschenkeln oder verlängerten Randschenkeln gelangende elektromagnetische Wellen werden ebenfall durch Reflexion und Absorption gedämpft.

Es ist besonders vorteilhaft, daß die labyrinthartigen Kantenbereiche zur Aufnahme einer zusätzlichen EMV-Dichtung geeignet sind. Beispielsweise kann ein EMV-Dichtungsstrang in die U- oder V-förmige Nut der labyrinthartigen Kantenbereiche eingelegt oder auch montiert werden, wodurch sich die Übergangswiderstände zwischen dem Deck- bzw. Bodenblech und den Seitenteilen weiter verringern und die EMV-Abschirmung verbessert wird.

In einer Weiterbildung des erfindungsgemäßen EMV-Schirmungskonzepts ist eine labyrinthartige Ausbildung auch im Bereich der Querprofile, insbesondere der frontseitigen Querprofile, gegenüber dem Deckblech und/oder Bodenblech vorgesehen, wobei auch bei dieser EMV-abgeschirmten Anordnung zusätzlich eine Dichtung zur Erhöhung der Abschirmung eingesetzt werden kann.

Das Deckblech und/oder Bodenblech weist im Bereich der Querprofile jeweils einen doppelwandigen Kantenbereich auf, welcher endseitig mit einem zweiten Randschenkel versehen ist. Dieser zweite Randschenkel ist vertikal ausgerichtet und greift in eine Nut des Querprofils ein, welche zweckmäßigerweise in einem zum Gehäuseinneren gerichteten Bereich und schlitzartig ausgebildet ist.

Der doppelwandige Kantenbereich umfaßt einen Auflageschenkel, welcher parallel zu dem eigentlichen Deckblech bzw. Bodenblech verläuft und im montierten Zustand auf dem jeweiligen Querprofil der Gehäuseanordnung aufliegt. Besonders vorteilhaft ist es, wenn der Auflageschenkel und das Querprofil derart dimensioniert sind, daß das Querprofil nahezu abgedeckt wird. Ein frontseitiger Schenkel zwischen dem Auflageschenkel und dem eigentlichen Deck- bzw. Bodenblech verläuft schräg nach hinten, so daß der Kantenbereich eine dachförmige Ausbildung aufweist. Insgesamt kann der doppelwandige Kantenbereich im Querschnitt auch als ein leicht verschobenes, liegendes "U" angesehen werden.

Die Nut im Querprofil ist komplementär zu dem endseitigen, zweiten Randschenkel des Deckblechs und/oder Bodenblechs ausgebildet. Auch dieser zweite Randschenkel verläuft über die gesamte Breite des Querprofils bzw. des Gehäuses und ist so ausgelegt, daß er nahezu vollständig in die Nut des Querprofils eintaucht. Durch die konstruktive Gestaltung als ein Labyrinth ergeben sich auch bei dieser Anordnung hohe Schirmdämpfungswerte.

Bei zusätzlicher Anordnung einer EMV-Dichtung ist es zweckmäßig, das Querprofil mit einem Befestigungssteg zu versehen, welcher die schlitzförmige Nut innenseitig begrenzt und zur Aufnahme einer EMV-Federleiste dient. Noppen- oder Spitzenkontakte an einem Federabschnitt, welcher bei aufgeschobener EMV-Federleiste in die Nut gerichtet ist, sorgen für eine wirkungsvolle Kontaktierung der Randschenkel und für hohe Schirmdämpfungswerte.

Die Erfindung wird nachstehend anhand einer Zeichnung weiter erläutert; in dieser zeigen in einer stark schematisierten Darstellung
- Fig. 1: eine erfindungsgemäße Anordnung zur EMV-Abschirmung im Bereich eines Seitenteils und eines Deckblechs eines Gehäuses;
- Fig. 2: eine erfindungsgemäße Anordnung gemäß Fig. 1, jedoch mit zusätzlicher EMV-Dichtung;
- Fig. 3: eine EMV-geschirmte Anordnung mit einem Deckblech und einem Querprofil eines Gehäuses und
- Fig. 4: die Anordnung gemäß Fig. 3 mit einer zusätzlichen EMV-Dichtung.

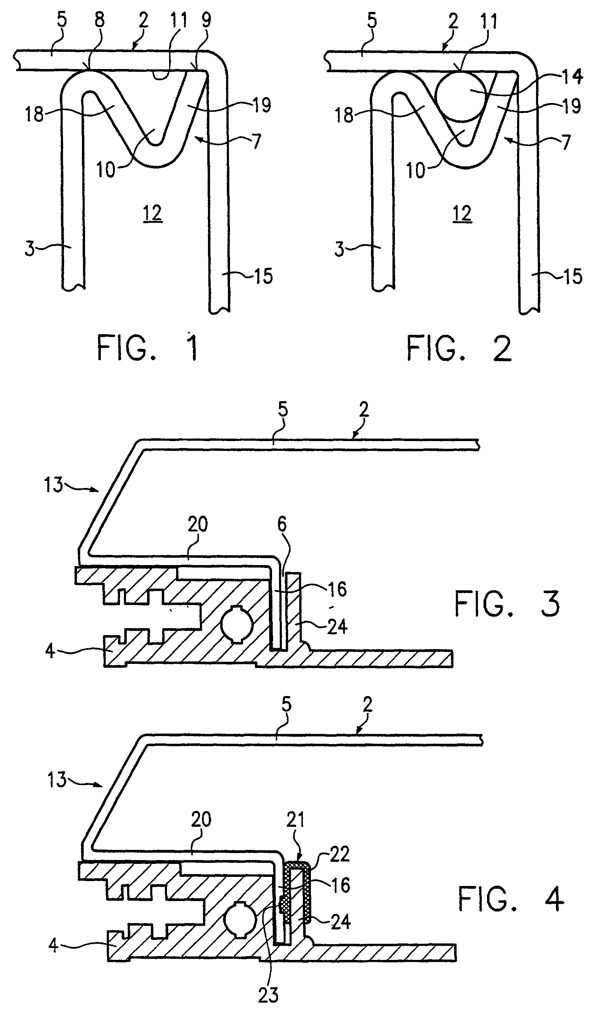

Fig. 1 und Fig. 2 zeigen einen Ausschnitt eines Gehäuses 2 im Bereich eines Seitenteils 3 und eines Deckblechs 5. Die analoge Anordnung kann bodenseitig zwischen dem Seitenteil 3 und einem Bodenblech ausgebildet sein (nicht dargestellt).

Um eine besonders hohe EMV-Abschirmung eines Gehäuses 2 zu erreichen, sind die Seitenteile 3 mit einem Labyrinthbug bzw. labyrinthartigen Kantenbereichen 7 versehen. Diese labyrinthartigen Kantenbereiche 7 sind im vorliegenden Ausführungsbeispiel Abkantungen oder Abbiegungen im Bereich der oberen Kanten, welche über die gesamte Tiefe bzw. Breite der Seitenteile 3 reichen. Durch die mehrfache Abbiegung sind zwei Auflagen 8, 9 für das Deckblech 5 gebildet, welche einen vorteilhaften Punkt- bzw. linienförmigen Kontakt bewirken. Außerdem ist der labyrinthartige Kantenbereich 7 als eine U- bzw. V-förmige Nut 10 ausgebildet, so daß sich der labyrinthartige Kantenbereich 7 nahezu als ein liegendes "Z" zeigt.

Eine besonders hohe Schirmwirkung wird erreicht, wenn das Deckblech 5 im Bereich der Seitenteile 3 einen ersten Randschenkel 15 aufweist, dessen Länge so bemessen ist, daß der labyrinthartige Kantenbereich 7 zumindest abgedeckt ist. Diese Abdeckung bedeutet, daß der erste Randschenkel 15, der parallel zum Seitenteil 3 verläuft, wenigstens bis zur, vorteilhafterweise jedoch über die U-bzw. V-förmige Nut 10 reicht.

Sowohl der labyrinthartige Kantenbereich 7 als auch das Deckblech 5 ist im Bereich der Auflagen 8, 9, zweckmäßigerweise jedoch im gesamten labyrinthartigen Kantenbereich 7 und somit auch in der Nut 10, mit einer metallischen Oberfläche versehen. Das Deckblech 5 ist in einem Auflagebereich 11, welcher von der innenseitigen Auflage 8 wenigstens bis zu dem abgewinkelten Randschenkel 15 reicht, ebenfalls metallisiert bzw. nicht lackiert.

Ein wesentlicher Vorteil der EMV-Abschirmung zwischen den Seitenteilen 3 und einem Deckblech 5 bzw. einem Bodenblech besteht darin, daß ohne einen Materialabrieb eine sehr hohe Dämpfung erreicht wird. Wenn der erste Randschenkel 15 des Deckblechs 5 bzw. Bodenblechs eine Länge aufweist, welche bei sehr hohen Frequenzen annähernd 4-Charakter aufweist, ist durch eine starke Reflexion und Absorption in den labyrinthartigen Kantenbereichen 7 eine erhebliche Abschwächung bzw. ein Auslöschen der elektromagnetischen Wellen gewährleistet, wobei dies sowohl in der U-förmigen Nut 10 als auch in einem Zwischenraum 12 zwischen dem Seitenteil 3 und dem ersten Randschenkel 15 erreicht wird.

Die vorteilhafte EMV-Abschirmung durch labyrinthartige Kantenausbildungen der Seitenteile 3 kann noch dadurch verbessert werden, daß die V-förmige Nut 10 mit einer EMV-Dichtung 14 versehen wird. Wenn diese EMV-Dichtung 14 dabei sowohl einen, bezogen auf den Gehäuseinnenraum, innenseitigen Verbindungsschenkel 18 als auch einen außenseitigen freien Schenkel 19 der V-förmigen Nut 10 und darüber hinaus das Deckblech 5 kontaktiert, zeigt die erfindungsgemäße Anordnung besonders gute Dämpfungseigenschaften.

In den Figuren 3 und Fig. 4 ist eine weitere labyrinthartige Anordnung zur EMV-Abschirmung in einem frontseitigen Bereich eines Gehäuses 2 dargestellt. Das Deckblech 5 ist mit einem zweiten Randschenkel 16 versehen und an einem Querprofil 4 fixiert. Das Deckblech 5 weist einen doppelwandigen Kantenbereich 13 auf, der nahezu dachförmig oder als ein liegendes "U" ausgebildet ist. Der endseitig angeordnete, vertikale Randschenkel 16 greift in eine Nut 6 des Querprofils 4 ein. Die Nut 6 ist komplementär zu diesem zweiten Randschenkel 16 dimensioniert und schlitzartig in einem zum Gehäuseinneren gerichteten Bereich des Querprofils 4 ausgebildet.

Ein nahezu horizontal angeordneter Auflageschenkel 20 verläuft parallel zu dem eigentlichen Deckblech 5 und ist derart dimensioniert, daß das Querprofil 4 nahezu abgedeckt ist. Auflageschenkel 20 und zweiter Randschenkel 16 reichen über die gesamte Breite des Querprofils 4 bzw. des Gehäuses 2. Der doppelwandige Kantenbereich 13 des Deckblechs 5 ist innenseitig ebenfalls nicht lackiert und weist somit eine metallische Oberfläche auf, ebenso wie das Querprofil 4 zumindest im Bereich der Nut 6 einen Metallkontakt gewährleistet. Die labyrinthartige Gestaltung der doppelwandigen Kantenbereiche 13 und die Auslegung der schlitzartigen Nut 6 und des zweiten Randschenkels 16 sichern eine hohe Schirmdämpfung.

Aus Fig. 4 geht hervor, daß durch eine EMV-Dichtung 21 die Abschirmung weiter verbessert werden kann. Die EMV- Dichtung 12 ist als eine Federleiste mit einem U-förmigen Federabschnitt 22 und Noppen- oder Spitzenkontakten 23 ausgebildet. Die Noppen- und Spitzenkontakte 23 kontaktieren den zweiten Randschenkel 16, und der U-förmige Federabschnitt 22 ist komplementär zu einem Befestigungssteg 24 des Querprofils 4 ausgebildet, so daß ein einfaches Aufschieben oder Aufstecken der EMV-Dichtung 21 möglich ist.

## Patentansprüche

1. Anordnung zur EMV-Abschirmung von Seitenteilen (3) und Querprofilen (4) eines Gehäuses (2), im Kontakt mit einem Deckblech (5) und/oder Bodenblech, welche erste und zweite Randschenkel (15, 16) aufweisen, wobei die ersten Randschenkel (15) im Bereich der Seitenteile (3) und die zweiten Randschenkel (16) im Bereich der Querprofile (4) angeordnet sind,
**dadurch gekennzeichnet,**
**dass** labyrinthartige Kantenbereiche (7) an den oberen und/oder unteren Kanten der Seitenteile (3) ausgebildet sind,
**dass** die labyrinthartigen Kantenbereiche (7) durch wenigstens zwei Auflagen (8, 9) für das Deckblech (5) und/oder Bodenblech gebildet sind und
**dass** die ersten Randschenkel (15) des Deckblechs (5) und/oder Bodenblechs, die parallel zum Seitenteil (3) verlaufen, über die labyrinthartigen Kantenbereiche (7) reichen.

2. Anordnung nach Anspruch 1,
**dadurch gekennzeichnet,**
**dass** die labyrinthartigen Kantenbereiche (7) durch Abbiegungen oder Abkantungen der Seitenteile (3) gebildet sind.

3. Anordnung nach Anspruch 1 oder 2,
**dadurch gekennzeichnet,**
**dass** die labyrinthartigen Kantenbereiche (7) wenigstens eine U- oder V-förmige Nut (10) aufweisen.

4. Anordnung nach einem der vorhergehenden Ansprüche,
**dadurch gekennzeichnet,**
**dass** die Auflage (8), bezogen auf den Innenraum des Gehäuses (2), als innenseitige Auflage (8) an einem Verbindungsschenkel (18) und die Auflage (9) als außenseitige Auflage (9) an einem freien Schenkel (19) der labyrinthartigen Kantenbereiche (7) ausgebildet sind und nahezu über die gesamte Länge der Seitenteile (3) reichen.

5. Anordnung nach einem der vorhergehenden Ansprüche,
**dadurch gekennzeichnet,**
**dass** die labyrinthartigen Kantenbereiche (7) wenigstens im Bereich der Auflagen (8, 9) sowie das Deckblech (5) und/oder das Bodenblech wenigstens in auf den Auflagen (8, 9) auf- oder anliegenden Bereichen eine metallische Oberfläche aufweisen.

6. Anordnung nach einem der vorhergehenden Ansprüche,
**dadurch gekennzeichnet,**
**dass** die U- oder V-förmige Nut (10) und die Auflagen (8, 9) sowie Auf- oder Anlagenbereiche (11) des Deckblechs (5) und/oder des Bodenblechs, welche jeweils wenigstens bis zu den ersten Randschenkeln (15) reichen, metallische Oberflächen aufweisen.

7. Anordnung nach einem der vorhergehenden Ansprüche,
**dadurch gekennzeichnet,**
**dass** die ersten Randschenkel (15) im Bereich der Seitenteile (3) als 90°-Abbiegungen oder -Abkantungen des Deckblechs (5) und/oder Bodenblechs ausgebildet sind, dass zwischen den ersten Randschenkeln (15) des Boden- und/oder Deckblechs (5, 6) und den Seitenteilen (3) ein Zwischenraum (12) gebildet ist und dass die ersten Randschenkel (15) eine derartige Länge aufweisen oder verlängerbar sind, dass die in den Zwischenraum (12) sowie in die Nut (10) gelangenden elektromagnetischen Wellen durch Reflexion und Absorption gedämpft werden.

8. Anordnung nach einem der vorhergehenden Ansprüche,
**dadurch gekennzeichnet,**
**dass** die labyrinthartigen Kantenbereiche (7) wenigstens eine EMV-Dichtung (14) aufweisen.

9. Anordnung nach Anspruch 8,
**dadurch gekennzeichnet,**
**dass** die EMV-Dichtung (14) als Dichtungsstrang ausgebildet und in der U- oder V-förmigen Nut (10) angeordnet ist.

10. Anordnung nach einem der vorhergehenden Ansprüche,
**dadurch gekennzeichnet,**
**dass** das Deckblech (5) und/oder Bodenblech im Bereich der Querprofile (4) doppelwandige Kantenbereiche (13) und einen zweiten Randschenkel (16) aufweisen, welcher in eine Nut (6) der Querprofile (4) eingreift, wobei die doppelwandigen Kantenbereiche (13) im Querschnitt dachförmig oder nahezu als ein liegendes U ausgebildet sind und der zweite Randschenkel (16) vertikal angeordnet ist.

11. Anordnung nach Anspruch 10,
**dadurch gekennzeichnet,**
**dass** die doppelwandigen Kantenbereiche (13) einen Auflageschenkel (20) aufweisen, welcher parallel zu dem Deckblech (5) und/oder Bodenblech ausgebildet und auf dem Querprofil (4) angeordnet ist.

12. Anordnung nach einem der Ansprüche 10 oder 11,
**dadurch gekennzeichnet,**
**dass** im Bereich der Nut (6), welche schlitzartig ausgebildet ist, eine EMV-Dichtung (21) angeordnet ist.

13. Anordnung nach Anspruch 12,
**dadurch gekennzeichnet,**
**dass** als EMV-Dichtung eine EMV-Federleiste (21) in der Nut (6) des Deckblechs (5) und/oder Bodenblechs angeordnet ist, welche den in der Nut (6) aufgenommenen, zweiten Randschenkel (16) kontaktiert.

14. Anordnung nach Anspruch 13,
**dadurch gekennzeichnet,**
**dass** die EMV-Federleiste (21) einen im Querschnitt U-förmigen Federabschnitt (22) zur Fixierung an dem Querprofil (4) und Noppen- oder Spitzenkontakte (23) zur Kontaktierung der zweiten Randschenkel (16) aufweist.

15. Anordnung nach Anspruch 14,
**dadurch gekennzeichnet,**
**dass** an den Querprofilen (4) ein Befestigungssteg (24) ausgebildet ist und dass die EMV-Federleiste (21) mit Ihrem U-förmigen Federabschnitt (22) lösbar an dem Befestigungssteg (24) fixierbar ist.

## Claims

1. Arrangement for electromagnetic EMC shielding of side parts (3) and transverse sections (4) of a housing (2) in contact with a cover plate (5) and/or a base plate which are provided with first and second marginal legs (15, 16), whereby the first marginal legs (15) are arranged in the vicinity of the side parts (3) and the second marginal legs (16) in the vicinity of the transverse sections (4),
**characterized in that**
labyrinth-like edge areas (7) are formed on the upper and/or lower edges of the side parts (3),
the labyrinth-like edge areas (7) are formed by at least two supports (8, 9) for the cover plate (5) and/or the base plate and
the first marginal legs (15) of the cover plate (5) and/or base plate which are oriented parallel to the side part (3) extend over and beyond the labyrinth-like edge areas (7).

2. Arrangement according to claim 1,
**characterized in that**
the labyrinth-like edge areas (7) are formed by bent portions of the side parts (3).

3. Arrangement according to claims 1 or 2,
**characterized in that**
the labyrinth-like edge areas have at least one U or V-shaped groove (10).

4. Arrangement according to one of the preceding claims,
**characterized in that**
the support (8) is, in relation to the interior of the housing (2), constructed as an inside support (8) on a connecting leg (18) and the support (9) is constructed as an outside support (9) on a free leg (19) of the labyrinth-like edge areas (7) and extend over virtually the entire length of the side parts (3).

5. Arrangement according to one of the preceding claims,
**characterized in that**
the labyrinths-like edge areas (7) have a metallic surface at least in the area of the supports (8, 9) and that the cover plate (5) and/or the base plate have a metallic surface at least in bearing areas resting on the supports (8, 9).

6. Arrangement according to one of the preceding claims,
**characterized in that**
the U or V-shaped groove (10) and the supports (8, 9) as well as bearing areas (11) of the cover plate (5) and/or the base plate which extend in each case at least to the first marginal legs (15), have metallic surfaces.

7. Arrangement according to one of the preceding claims,
**characterized in that**
the first marginal legs (15) in the area of the side parts (3) are constructed as a 90° bend or bevel of the cover plate (5) and/or base plate, that an intermediate space (12) is form between the first marginal legs (15) of the base plate and/or cover plate (5) and the side parts (3) and that the first marginal legs (15) have such a length or are extendible in such a wax that the electromagnetic waves entering the intermediate space (12) and groove (10) are attenuated by reflection and absorption.

8. Arrangement according to one of the preceding claims,
**characterized in that**
the labyrinth-like edge areas (7) have at least one EMC seal (14).

9. Arrangement according to claim 8,
**characterized in that**
the EMC seal (14) is constructed as a sealing strand and is placed in the U or V-shaped groove (10).

10. Arrangement according to one of the preceding claims,
**characterized in that**
the cover plate (5) and/or base plate have in the vicinity of the transverse sections (4), double-walled edge areas (13) and a second marginal leg (16) which engages in a groove (6) of the transverse sections (4), whereby, in crossection, the double-walled edge areas (13) are constructed like a roof or virtually as a horizontal U and the second marginal leg (16) is positioned vertically.

11. Arrangement according to claim 10,
**characterized in that**
the double-walled edge areas (13) have a bearing leg (20) which is constructed parallel to the cover plate (5) and/or base plate and rests on the transverse section (4).

12. Arrangement according to one of the claims 10 or 11,
**characterized in that**
an EMC seal (21) is located in the groove (6) which is slot-like designed.

13. Arrangement according to claim 12,
**characterized in that**
as EMC seal an EMC spring contact strip (21) is located in the groove (6) of the cover plate (5) and/or base plate contacting the second marginal leg (16) received in the groove (6).

14. Arrangement according to claim 13,
**characterized in that**
the EMC spring contact strip (21) has a cross-sectionally U-shaped spring section (22) for fixing to the transverse section (4) and stud or point contacts (23) for contacting the second marginal leg (16).

15. Arrangement according to claim 14,
**characterized in that**
a fastening web (24) is constructed on the transverse sections (4) and that the EMC spring contact strip (21) is detachably fixed by its U-shaped spring section (22) to the fastening web (24).

## Revendications

1. Dispositif destiné à blinder électromagnétiquement des parties latérales (3) et des profils transversaux (4) d'un boîtier (2), en contact avec une tôle de recouvrement (5) et/ou une tôle de fond, lesquels présentent de premières et de deuxièmes branches de bord (15, 16), les premières branches de bord (15) étant disposées dans la zone des parties latérales (3) et les deuxièmes branches de bord (16) dans la zone des profils transversaux (4),
**caractérisé en ce que**
des zones d'arête (7) en forme de labyrinthe sont formées sur les arêtes supérieures et/ou inférieures des parties latérales (3),
les zones d'arête (7) en forme de labyrinthe sont formées par au moins deux appuis (8, 9) pour la tôle de recouvrement (5) et/ou la tôle de fond et
les premières branches de bord (15) de la tôle de recouvrement (5) et/ou de la tôle de fond qui sont parallèles à la partie latérale (3) s'étendent au-delà des zones d'arête (7) en forme de labyrinthe.

2. Dispositif selon la revendication 1,
**caractérisé en ce que**
les zones d'arête (7) en forme de labyrinthe sont formées par des courbures ou par des pliures des parties latérales (3).

3. Dispositif selon la revendication 1 ou 2,
**caractérisé en ce que**
les zones d'arête (7) en forme de labyrinthe présentent au moins une rainure (10) en U ou en V.

4. Dispositif selon l'une des revendications précédentes,
**caractérisé en ce que**
l'appui (8), si on se réfère à l'espace intérieur du boîtier (2), est formé en tant qu'appui (8) interne sur une branche de liaison (18) et l'appui (9) en tant qu'appui (9) externe sur une branche (19) libre des zones d'arête (7) en forme de labyrinthe, et ils s'étendent presque sur toute la longueur des parties latérales (3).

5. Dispositif selon l'une des revendications précédentes,
**caractérisé en ce que**
les zones d'arête (7) en forme de labyrinthe, au moins dans la zone des appuis (8, 9), ainsi que la tôle de recouvrement (5) et/ou la tôle de fond, au moins sur des zones situées par-dessus ou à côté des appuis (8, 9), présentent une surface métallique.

6. Dispositif selon l'une des revendications précédentes,
**caractérisé en ce que**
la rainure (10) en U ou en V et les appuis (8, 9) ainsi que les zones (11) situées par-dessus ou à côté de la tôle de recouvrement (5) et/ou de la tôle de fond qui s'étendent chacune au moins jusqu'aux premières branches de bord (15) présentent des surfaces métalliques.

7. Dispositif selon l'une des revendications précédentes,
**caractérisé en ce que**
dans la zone des parties latérales (3), les premières branches de bord (15) prennent la forme de courbures ou de pliures à 90° de la tôle de recouvrement (5) et ou de la tôle de fond, un espace intermédiaire (12) est formé entre d'une part les premières branches de bord (15) de la tôle de recouvrement (5) et/ou de la tôle de fond et d'autre part les parties latérales (3), et les premières branches de bord (15) ont une longueur telle ou peuvent être prolongées de telle manière que les ondes magnétiques qui parviennent dans l'espace intermédiaire (12) ainsi que dans la rainure (10) sont atténuées par réflexion et par absorption.

8. Dispositif selon l'une des revendications précédentes,
**caractérisé en ce que**
les zones d'arête (7) en forme de labyrinthe présentent au moins une garniture d'étanchéité électromagnétique (14).

9. Dispositif selon la revendication 8,
**caractérisé en ce que**
la garniture d'étanchéité électromagnétique (14) est conçue sous forme de cordon d'étanchéité et est disposée dans la rainure (10) en U ou en V.

10. Dispositif selon l'une des revendications précédentes,
**caractérisé en ce que**
dans la zone des profils transversaux (4), la tôle de recouvrement (5) et/ou la tôle de fond présentent des zones d'arête (13) à double paroi et une deuxième branche de bord (16) qui a prise dans une rainure (6) des profils transversaux (4), les zones d'arête (13) à double paroi en section transversale ayant une forme de toit ou une forme proche d'un U couché et la deuxième branche de bord (16) étant placée à la verticale.

11. Dispositif selon la revendication 10,
**caractérisé en ce que**
les zones d'arête (13) à double paroi présentent une branche d'appui (20) qui est parallèle à la tôle de recouvrement (5) et/ou à la tôle de fond, et qui est disposée sur le profil transversal (4.)

12. Dispositif selon l'une des revendications 10 ou 11,
**caractérisé en ce qu'**
une garniture d'étanchéité électromagnétique (21) est disposée dans la zone de la rainure (6) en forme de fente.

13. Dispositif selon la revendication 12,
**caractérisé en ce que**
comme garniture d'étanchéité électromagnétique, dans la rainure (6) de la tôle de recouvrement (5) et/ou de la tôle de fond on dispose, un jack à ressorts (21) électromagnétique qui est en contact avec la deuxième branche de bord (16) reçue dans la rainure (6).

14. Dispositif selon la revendication 13,
**caractérisé en ce que**
en section transversale, le jack à ressorts (21) électromagnétique présente une section de ressort (22) en U destinée à la fixation au profil transversal (4) et des contacts (23) en relief ou à pointe destinés à contacter les deuxièmes branches de bord (16).

15. Dispositif selon la revendication 14,
**caractérisé en ce qu'**
une languette de fixation (24) est formée sur les profils transversaux (4) et, par sa section de ressort (22) en U, on peut fixer le jack à ressorts (21) électromagnétique de façon amovible sur la languette de fixation (24).
